Europäisches Patentamt

European Patent Office

Office européen des brevets

Veröffentlichungsnummer: **0 292 077**

**A2**

# EUROPÄISCHE PATENTANMELDUNG

Anmeldenummer: **88201006.9**

Int. Cl.⁴: **H03B 5/12**

Anmeldetag: **19.05.88**

Priorität: **20.05.87 DE 3716878**

Veröffentlichungstag der Anmeldung:
**23.11.88 Patentblatt 88/47**

Benannte Vertragsstaaten:
**DE ES FR GB**

Anmelder: **Philips Patentverwaltung GmbH**
**Wendenstrasse 35 Postfach 10 51 49**
**D-2000 Hamburg 1(DE)**

**DE**

Anmelder: **N.V. Philips' Gloeilampenfabrieken**
**Groenewoudseweg 1**
**NL-5621 BA Eindhoven(NL)**

**ES FR GB**

Erfinder: **Kupfer, Karl-Heinz**
**Krefelder Strasse 145**
**D-4150 Krefeld 29(DE)**

Vertreter: **Kupfermann, Fritz-Joachim,**
**Dipl.-Ing. et al**
**Philips Patentverwaltung GmbH**
**Wendenstrasse 35 Postfach 10 51 49**
**D-2000 Hamburg 1(DE)**

**ZF-Oszillator für HF-Tuner.**

Bei einer Schaltungsanordnung eines ZF-Oszillators für einen HF-Tuner, die für zwei Frequenzbänder umschaltbar ist und einen rückgekoppelten Transistor und eine Parallelschaltung aufweist, die aus einer Serienkapazität einer Kapazitätsdiode und einer Reihenschaltung einer ersten und einer zweiten Induktivität aufgebaut ist, welche im höheren Frequenzband stark bedämpft ist, ist zur Stabilisierung des Oszillatorpegels und zur Frequenzband-Umschaltung eine Schaltdiode vorgesehen, deren Kathode mit dem Verbindungspunkt zwischen den beiden Induktivitäten und einer positiven Versorgungsspannung gekoppelt ist und deren Anode mit einer positiven Schaltspannung und über eine Kapazität mit Masse verbunden ist.

FIG.1

## ZF-Oszillator für HF-Tuner

Die Erfindung bezieht sich auf eine Schaltungsanordnung eines ZF-Oszillators für einen HF-Tuner, insbesondere Fernsehtuner, die für zwei Frequenzbänder umschaltbar ist und einen rückgekoppelten Transistor und einen Parallelschwingkreis aufweist, der aus einer Serienkapazität, einer Kapazitätsdiode und einer Reihenschaltung, einer ersten und einer zweiten Induktivität aufgebaut ist, welche im höheren Frequenzband stark bedämpft wird, wobei zur Frequenzbandumschaltung eine Schaltdiode vorgesehen ist, deren Kathode mit dem Verbindungspunkt zwischen den beiden Induktivitäten und einer positiven Versorgungsspannung gekoppelt ist und deren Anode mit einer positiven Schaltspannung und über eine Kapazität mit Masse verbunden ist.

Bei ZF-Oszillatoren mit einem Parallelschwingkreis sind zwei in Reihe geschaltete Induktivitäten vorgesehen, die bei Betrieb des Tuners im niederfrequenten Frequenzband beide wirksam sind. Bei Betrieb in dem höherfrequenten Frequenzband ist eine der Induktivitäten stark bedämpft, indem sie überbrückt wird. Diese Umschaltung wird im allgemeinen mittels zweier Schaltspannungen, zweier Schaltdioden und einer weiteren, dritten Induktivität vorgenommen. Mittels der Schaltspannungen werden die Schaltdioden jeweils so geschaltet, daß zu der umzuschaltenden Induktivität entweder eine hochohmige oder eine niederohmige Reaktanz parallel liegt. Auf diese Weise wird die Induktivität mehr oder weniger stark bedämpft, so daß eine Umschaltung der Resonanzfrequenz des Parallelschwing kreises möglich ist. Eine dritte Induktivität ist meist erforderlich, um HF-Signale von der Umschaltvorrichtung abzublocken. Der Hauptnachteil derartiger Oszillatorschaltungen besteht jedoch darin, daß die Rückkopplung des Transistors zur Speisung des Serienschwingkreises nicht optimal in beiden Frequenzbändern arbeitet. Dies wiederum hat zur Folge, daß in den Frequenzbändern stark unterschiedliche Pegel des Oszillatorsignals auftreten. Dies führt zu Schwierigkeiten bei der Ankopplung eines nachfolgenden ZF-Mischers. Außerdem treten Schwierigkeiten bei der Einhaltung postalischer Bestimmungen auf (FTZ - Amtsblatt DP 69/1981 und 17 MV6).

Es ist Aufgabe der vorliegenden Erfindung, eine Oszillatorschaltung anzugeben, welche bei möglichst geringem Bauteileaufwand auch beim Umschalten zwischen zwei Frequenzbändern einen weitgehend konstanten Pegel der Oszillatoramplitude gewährleistet.

Diese Aufgabe ist erfindungsgemäß dadurch gelöst, daß die Rückkopplung des Transistors mittels einer ersten, mit der Kathode der Schaltdiode verbunden und einer zweiten, mit dem Verbindungspunkt zwischen der Kapazitätsdiode und der Serienkapazität gekoppelten Kapazität vorgenommen ist.

Es sind also für den Transistor, der den ...ienschwingkreis speist, zwei Rückkopplungen vorgesehen. Die erste Rückkopplung greift das Signal an der Kathode der Schaltdiode ab. Diese Rückkopplung ist somit nur dann wirksam, wenn die Schaltdiode gesperrt ist, d. h. also im niedrigerfrequenten Frequenzband. Im höherfrequenten Frequenzband wird das an der Kathode anliegende Signal des Oszillators über die Schaltdiode und eine Kapazität nach Masse abgeleitet, so daß nur sehr geringe Spannungswerte auftreten.

Die zweite Rückkopplung greift das Signal zwischen der Kapazitätsdiode, die der Abstimmung des Serienschwingkreises dient, und der Serienkapazität ab. An dieser Stelle des Serienschwingkreises ist bei Betrieb in beiden Frequenzbändern ein Signal vorhanden, so daß diese Rückkopplung in beiden Frequenzbändern wirksam ist; die Wirksamkeit der Rückkopplung ist jedoch in beiden Frequenzbändern abhängig von der Kapazität der Kapazitätsdiode. Diese zweite Rückkopplung ist daher in dem jeweils unteren Bereich der beiden Frequenzbänder wirksam, da dann die Kapazität der Kapazitätsdiode relativ groß und die an dem Verbindungspunkt zwischen der Serienkapazität und der Kapazitätsdiode auftretende Spannung relativ groß ist.

Die Kombination dieser beiden Rückkopplungen bietet vor allem den Vorteil, daß der Betrieb der ersten Rückkopplung ausschließlich im unteren Frequenzband eine optimale Auslegung beider Rückkopplungen gestattet. Die zweite Rückkopplung, die die Spannung am Verbindungspunkt zwischen der Serienkapazität und der kapazitätsdiode abgreift, kann somit für das obere Frequenzband optimiert werden. Im unteren Frequenzband ist zusätzlich die erste Rückkopplung wirksam, die wiederum so ausgelegt werden kann, daß bei Betrieb in diesem Frequenzband beide Rückkopplungen gemeinsam optimal arbeiten. Optimale Rückkopplungsverhältnisse sind vor allem für ein gutes Schwingungsverhalten von Bedeutung, da auf diese Weise eine günstige Reaktion der Schaltungsanordnung auf Veränderungen der Versorgungsspannung oder auf Temperaturschwankungen erzielt wird.

Nach einer weiteren Ausgestaltung der Erfindung ist vorgesehen, daß eine Ankopplung eines nachgeschalteten ZF-Mischers über eine erste, mit der Kathode der Schaltdiode verbundene und eine zweite, mit dem Verbindungspunkt zwischen Kapazitätsdiode und Serienkapazität verbundene Kapazität vorgesehen ist.

Eine derartige Ankopplung eines nachgeschalteten ZF-Mischers stabilisiert zusätzlich den Pegel des ihm zugeführten Oszillatorsignals, da auf diese Weise vor allem die beim Betrieb im unteren Frequenzband wirksam werdende Amplitudenbegrenzung des Oszillatorsignals für die Mischerankopplung besonders wirksam ist.

Zur Umschaltung zwischen den zwei Frequenzbändern ist nur noch eine Schaltdiode vorgesehen. Die Kathode der Schaltdiode ist mit dem Verbindungspunkt zwischen den beiden Induktivitäten gekoppelt, ebenso wie mit einer positiven, dauernd anliegenden Versorgungsspannung. Die Anode der Schaltdiode ist mit einer positiven Schaltspannung gekoppelt, die nur bei Betrieb des höherfrequenten Frequenzbandes vorhanden ist. Ferner ist die Anode der Schaltdiode über eine Kapazität mit Masse verbunden.

Bei Betrieb in dem niedrigerfrequenten Frequenzband liegt an der Kathode der Schaltdiode eine dauernd vorhandene Versorgungsspannung an, die Anode jedoch ist nicht mit der positiven Schaltspannung beaufschlagt. Aus diesem Grunde sperrt die Schaltdiode, so daß der Verbindungspunkt zwischen den beiden Induktivitäten von dieser Umschaltvorrichtung her nur hochohmig beeinflußt ist. Infolgedessen sind beide in Reihe geschalteten Induktivitäten des Serienschwingkreises wirksam.

Beim Betrieb in dem höherfrequenten Frequenzband ist die positive Versorgungsspannung nach wie vor mit der Kathode der Schaltdiode gekoppelt. Es liegt nun jedoch an der Anode die positive Schaltspannung an, die so gewählt ist, daß die Schaltdiode leitend wird. Das an dem Verbindungspunkt zwischen den beiden Induktivitäten anliegende Oszillatorsignal gelangt nun über die Schaltdiode und die gegen Masse geschaltete Kapazität auf Masse. Auf diese Weise ist die zweite Induktivität im wesentlichen wirkungslos. Infolge der geringeren Induktivität im Serienschwingkreis erhöht sich die Resonanzfrequenz des Serienschwingkreises.

Mit dieser einfachen Schaltungsanordnung des ZF-Oszillators ist eine Umschaltung zwischen zwei Frequenzbändern auf einfache Weise möglich. Es werden hierzu lediglich, neben weiteren passiven Bauelementen, eine Schaltdiode und eine Schaltspannung benötigt. Der Einsatz einer zusätzlichen Induktivität zum Abblocken des Oszillatorsignals von der Umschaltanordnung entfällt. Die Schaltungsanordnung ist somit wirtschaftlich in ihrem Aufbau.

Nach einer weiteren Ausgestaltung der Erfindung ist vorgesehen, daß die Kathode der Schaltdiode über einen Widerstand mit der Versorgungsspannung gekoppelt ist, welcher so dimensioniert ist, daß bei nicht vorhandener Schaltspannung die Schaltdiode nur leitend geschaltet wird, wenn die negativen Halbwellen der Oszillatorspannung einen vorgegebene Spannungswert unterschreiten.

Die Kopplung der dauernd vorhandenen Versorgungsspannung mit der Kathode der Schaltdiode wird vorteilhafterweise über einen Widerstand vorgenommen. Der Wert dieses Widerstandes muß einerseits so gewählt sein, daß bei Betrieb im höherfrequenten Frequenzband die Schaltdiode infolge der positiven Schaltspannung in jedem Falle noch sicher durchgeschaltet ist. Bei Betrieb im niederfrequenten Frequenz band ist die positive Schaltspannung an der Anode nicht vorhanden. Es stellt sich dann infolge der über den Widerstand der Kathode der Schaltdiode zugeleiteten Versorgungsspannung an der Kathode ein positiver Gleichspannungswert ein, der von dem Wechselspannungssignal des Oszillators überlagert wird. Der Wert des Widerstandes, der die Versorgungsspannung mit der Kathode der Schaltdiode koppelt, kann nun vorteilhafterweise so gewählt werden, daß eine Begrenzung der negativen Halbwelle des Oszillatorsignales erfolgt, sobald diese einen vorgegebenen Spannungswert unterschreitet. Dies geschieht dadurch, daß die negative Halbwelle des Oszillatorsignals einen beträgsmäßig um soviel größeren Spannungswert annimmt als die an der Kathode der Schaltdiode anliegende Gleichspannung, daß die Schaltdiode leitend wird, solange diese Bedingung erfüllt ist. Auf diese Weise wird die negative Halbwelle der Oszillatoramplitude begrenzt. Die Wahl des Spannungswertes, auf den die negative Halbwelle begrenzt wird, kann auf einfache Weise durch geeignete Wahl des Widerstandswertes des Widerstandes vorgenommen werden, über den die Kathode mit der positiven Versorgungsspannung gekoppelt ist.

Die Schaltungsanordnung übernimmt auf diese Weise eine zusätzliche Begrenzungsfunktion, die in dem unteren Frequenzband wirksam ist, in dem der Serienschwingkreis höhere Spannungswerte des Oszillatorsignals liefert. Bei geeigneter Wahl des Wertes des obengenannten Widerstandes ist es so möglich, in dem niederfrequenten Frequenzband eine Amplitude des Oszillatorsignals zu erhalten, die etwa der Amplitude des Signals im höherfrequenten Frequenzband entspricht. Der Vorteil der Schaltungsanordnung liegt vor allem darin, daß für diese Pegelbegrenzung keine zusätzlichen Bauelemente notwendig sind, sondern daß vielmehr die Teile der Schaltungsanordnung für die Umschaltung zwischen den beiden Frequenzbändern gleichzeitig auch zur Pegelbegrenzung im niederen Frequenzband herangezogen werden.

Nach einer weiteren Ausgestaltung der Erfindung ist vorgesehen, daß die Kathode der Schaltdiode über eine Parallelschaltung einer Kapazität und eines Widerstandes mit dem Verbindungspunkt zwischen den beiden Induktivitäten gekoppelt ist. Diese Art der Kopplung bietet bei Betrieb im höherfrequenten Frequenzband sowohl den Signalweg des Oszillatorsignals über die Schaltdiode wie auch einen Signalweg für den Gleichspannungsschaltstrom durch die Schaltdiode, der bei Einsatz einer solchen Kopplung über den Widerstand der Parallelschaltung und über die zweite Induktivität nach Masse hin abfließt. Auf diese Weise wird also die zweite Induktivität bei Betrieb im höherfrequenten Frequenzband zur Ableitung des Schaltgleichstromes der Schaltdiode benutzt.

Anhand der Zeichnungen werden zwei Ausführungsbeispiele der Erfindung näher erläutert. Es zeigen:.

Fig. 1 eine Schaltungsanordnung eines ZF-Oszillators mit Pegelbegrenzung des Oszillatorsignals im niedrigerfrequenten Frequenzband,

Fig. 2 die Schaltungsanordnung nach Fig. 1 mit einer Auskopplung des ZF-Mischersignals auch an der Kathode der zu Umschaltung der Frequenzbänder vorgesehenen Schaltdiode.

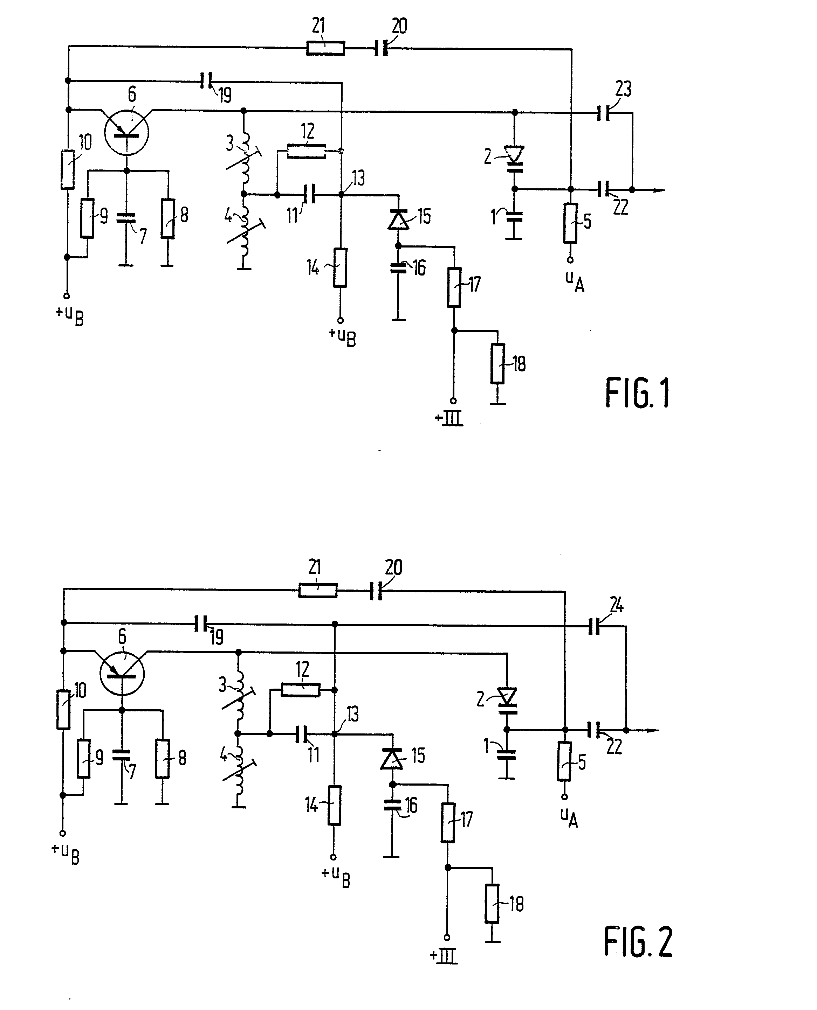

Die in Fig. 1 dargestellte Schaltungsanordnung weist einen Parallelschwingkreis auf, der aus der Reihenschaltung einer Serienkapazität 1, einer Kapazitätsdiode 2, einer ersten Induktivität 3 und einer zweiten Induktivität 4 aufgebaut ist, von denen die Serienkapazität 1 und die zweite Induktivität 4 gegen Masse geschaltet sind.

Diese vier Bauelemente bilden im wesentlichen den Parallelschwingkreis, dessen Frequenz mittels der Kapazitätsdiode 2 abgestimmt werden kann, die mit ihrer Kathode zum einen mit der Serienkapazität 1 und zum anderen mit einem Widerstand 5 vebunden ist, über den der Kapazitätsdiode zur Abstimmung des Parallelschwingkreises eine Abstimmspannung $U_A$ zugeführt ist. Der Parallelschwingkreis wird mittels eines in Basisschaltung arbeitenden Transistors 6 gespeist. Die Basis des Transistors 6 ist über die Parallelschaltung einer Kapazität 7 und eines Widerstandes 8 mit Masse verbunden. Ferner ist sowohl der Basis als auch dem Emitter des Transistors 6 über je einen Widerstand 9 bzw. 10 eine positive Versorgungsspannung $U_B$ zugeführt. Der Kollektor des Transistors 6 ist mit dem Verbindungspunkt zwischen der ersten Induktivität 3 und der Anode der Kapazitätsdiode 2 verbunden.

Zur Umschaltung zwischen zwei Frequenzbändern ist der Verbindungspunkt zwischen der ersten Induktivität 3 und der zweiten Induktivität 4 über eine Parallelschaltung einer Kapazität 11 und eines Widerstandes 12 mit einem Verbindungspunkt 13 verbunden. Dieser Verbindungspunkt 13 ist zum einen über einen Widerstand 14 mit der positiven Versorgungsspannung $U_B$ und zum anderen mit der Kathode einer Schaltdiode 15 verbunden. Die Anode der Schaltdiode 15 ist über eine Kapazität 16 mit Masse verbunden. Ferner ist die Anode mit zwei in Reihe geschalteten Widerstäänden 17 und 18 verbunden, wobei dem Verbindungspunkt zwischen diesen beiden Widerständen eine positive Schaltgleichspannung zugeführt ist. Der Widerstand 18 ist auf Masse geführt.

Die Rückkopplung zwischen dem Serienschwingkreis und dem Versorgungtransistor 6 ist zum einen über eine Kapazität 19 vorgesehen, die mit der Kathode der Schaltdiode 15 und dem Emitter des Transistors 6 verbunden ist. Eine zweite Rückkopplung führt von dem Verbindungspunkt zwischen der Serienkapazität 1 und der Kapazitätsdiode 2 über eine Kapazität 20 und einen Widerstand 21 ebenfalls zum Emitter des Transistors 6.

Das einem in der Figur nicht dargestellten ZF-Mischer zugeführte Signal wird über eine Kapazität 22 an dem Verbindungspunkt zwischen der Serienkapazität 1 und der Kapazitätsdiode 2 und über eine Kapazität 23 an der Anode der Kapazitätsdiode 2 ausgekoppelt.

Die Oszillatorschaltung ist in ihrer Frequenz für zwei Frequenzbänder umschaltbar ausgelegt. Die Umschaltung zwischen diesen beiden Frequenzbändern wird mittels der über den Widerstand 17 an die Anode der Schaltdide 15 angelegten Schaltgleichspannung vorgenommen. Bei nicht anliegender Schaltgleichspannung ist die Schaltdiode 15 gesperrt, da an ihrer Kathode die über den Widerstand 14 dauernd anliegende Versorgungsgleichspannung $U_B$ die Schaltdiode sperrt. In diesem Fall sind beide Induktivitäten 3 und 4 des Serienschwingkreises wirksam, so daß dieser auf einer relativ niedrigeren Frequenz schwingt. Vorteilhafterweise wird der Wert des Widerstandes 14 so gewählt, daß die negative Halbwelle des ZF-Oszillatorsignals, das über die Kapazität 11 an dem Verbindungspunkt 13 und damit auch an der Kathode der Schaltdiode 15 anliegt, auf einen vorgebenen, gewünschten Spannungswert begrenzt wird. Dies geschieht in der Weise, daß beispielsweise mittels der Versorgungsspannung $U_B$ und des Widerstandes 14 an der Kathode der Schaltdiode 15 eine Gleichspannung von 2,5 V eingestellt wird. Unterschreitet nun die negative Halbwelle der Oszillatoramplitude etwa einen Wert von etwa -2,5 V, so wird die Schaltdiode 15 langsam leitend und führt das Oszillatorsignal über die Kapazität 16 auf Masse ab. Auf diese Weise kann die negative Halbwelle der Oszillatoramplitude begrenzt werden. Die Wahl des Spannungswertes, auf den die negative Halbwelle begrenzt wird, wird hierbei im wesentlichen mittels geeigneter Wahl des Wertes des Widerstandes 14 vorgenommen. Diese Begrenzung im niedrigeren Frequenzband ist vor allem deshalb von Vorteil, weil in diesem Band höhere Pegel der Oszillatoramplitude auftreten als im höheren Frequenzband.

Für den Betrieb der Oszillatorschaltung für das höherfrequente Frequenzband wird über den Widerstand 17 eine positive Schaltgleichspannung an die Anode der Schaltdiode 15 gelegt. Die Größe dieser an der Anode der Schaltdiode 15 anliegenden Schaltspannung ist so gewählt, daß die Schaltdiode trotz der an ihrer Kathode anliegenden Gleichspannung leitend wird. Das Oszillatorsignal gelangt nun im wesentlichen von dem Verbindungspunkt zwischen den Induktivitäten 3 und 4 über die Kapazität 11, die Schaltdiode 15 und die Kapazität 16 auf Masse, so daß die zweite Induktivität 4 im wesentlichen unwirksam ist. Der Parallelschwingkreis schwingt nun auf einer höheren Frequenz. Der Schaltstrom für die Schaltdiode 15 fließt über den Widerstand 17, die Schaltdiode selbst, den Widerstand 12 und die Induktivität 4, die auf diese Weise bei Betrieb des Oszillators für das höhere Frequenzband gleichzeitig auch zur Ableitung diese Gleichstromes genutzt wird.

Die erste Rückkopplung, die von dem Verbindungspunkt 13 zum Emitter des Transistors 6 führt, ist im wesentlichen nur bei Betrieb im niedrigeren Frequenzband wirksam, da nur in diesem Falle an dem Verbindungspunkt 13 das ZF-Oszillatorsignal in genügender Amplitude vorhanden ist. Bei Betrieb im höheren Frequenzband ist die Schaltdiode 15 leitend, und an dem Verbindungspunk 13 treten nur sehr geringe Spannungswerte des Oszillatorsignals auf, da dieses über die Schaltdiode 15 und die Kapazität 16 gegen Masse geführt ist. Die zweite Rückkopplungsschaltung, die ebenfalls zum Emitter des Transistors 6 führt, greift das am Verbinungspunkt zwischen der Serienkapazität 1 und der Kapazitätsdiode 2 anliegende Signal ab. Diese Rückkopplung ist in beiden Frequenzbändern wirksam, jedoch jeweils nur in dem unteren Bereich der Frequenzbänder, da in diesem Bereich die Kapazität de Kapazitätsdiode relativ groß ist und somit an dem Verbindungspunkt auch relativ große Spannungen auftreten, die zum Transistor 6 rückgekoppelt werden. Dadurch, daß die Rückkopplung über die Kapazität 19 nur in dem unteren Frequenzband wirksam ist, kann die Rückkopplung über die Kapazität 20 und dem Widerstand 21 für das obere Frequenzband optimiert werden. Für das untere Frequenzband wird dann der Wert der Kapazität 19 so ausgelegt, daß sich auch für dieses Frequenzband eine optimale Rückkopplung ergibt. Die Rückkopplung über die Kapazität 19 berücksichtigt in besonderer Weise auch die Begrenzung des Oszillatorsignal bei Betrieb in dem unteren Frequenzband.

Diese Begrenzung des Oszillatorsignal an dem Verbindungspunkt 13 wird bei einer zweiten Ausführungsform der Schaltungsanordnung, die in Fig. 2 dargestellt ist und die bis auf die Mischer-Ankopplung mit der in Fig. 1 dargestellten übereinstimmt, auch zu einer geeigneten Ankopplung eines in der Figur nicht dargestellten, nachfolgenden ZF-Mischers genutzt. Wird nämlich das ZF-Mischersignal u. a. an dem Verbindungspunkt 13 entnommen, wie dies in der in Fig. 2 dargestellten Ausführungsform der Schaltungsanordnung der Fall ist, so ist bei Betrieb in dem niederfrequenten Frequenzband auch für die Mischer-Ankopplung die an dem Verbndungspunkt 13 vorhandene Pegelbegrenzung des Oszillatorsignales direkt wirksam. Daher ist bei der in Fig. 2 dargestellten Schaltungsvariante das ZF-Mischersignal über eine Kapazität 24 an dem Verbindungspunkt 13 ausgekoppelt. Zusätzlich ist das Mischersignal, ebenso wie bei der in Fig. 1 dargestellten Schaltungsvariante über die Kapazität 22 an dem Verbindungspunkt zwischen der Serienkapazität 1 und der Kapazitätsdiode 2 ausgekoppelt. Zusammen mit dieser Variante der ZF-Mischerauskopplung ergibt sich für die in Fig. 2 dargestellte Schaltungsanordnung ein nahezu konstanter Pegel des Oszillatorsignals für Abstimmung der Schaltung in beiden Frequenzbändern.

**Ansprüche**

1. Schaltungsanordnung eines ZF-Oszillators für einen HF-Tuner, insbesondere Fernsehtuner, die für zwei Frequenzbänder umschaltbar ist und einen rückgekoppelten Transistor und einen Parallelschwingkreis aufweist, der aus einer Serienkapazität, einer Kapazitätsdiode und einer Reihenschaltung, einer ersten und einer zweiten Induktivität aufgebaut ist, welche im höheren Frequenzband stark bedämpft wird, wobei zur Frequenzbandumschaltung eine Schaltdiode vorgesehen ist, deren Kathode mit dem Verbindungspunkt zwischen den beiden Induktivitäten und einer positiven Versorgungsspannung gekoppelt ist und deren Anode mit einer positiven Schaltspannung und über eine Kapazität mit Masse verbunden ist, dadurch gekennzeichnet, daß die Rückkopplung des Transistors mittels einer ersten, mit der Kathode der Schaltdiode verbundenen und einer zweiten, mit dem Verbindungspunkt zwischen der Kapazitätsdiode und der Serienkapazität gekoppelten Kapazität vorgenommen ist.

2. Schaltungsanordnung nach Anspruch 1, dadurch gekennzeichnet, daß eine Ankopplung eines nachgeschalteten ZF-Mischers über eine erste, mit der Kathode der Schaltdiode verbundene und eine zweite, mit dem Verbindungspunkt zwischen Kapazitätsdiode und Serienkapazität verbundene Kapazität vorgesehen ist.

3. Schaltungsanordnung nach Anspruch 1 oder 2, dadurch gekennzeichnet, daß die Kathode der Schaltdiode über einen Widerstand mit der Versorgungsspannung gekoppelt ist, welcher so dimensioniert ist, daß bei nicht vorhandener Schaltspannung die Schaltdiode nur leitend geschaltet wird, wenn die negativen Halbwellen der Oszillatorspannung einen vorgegebenen Spannungswert unterschreiten.

4. Schaltungsanordnung nach Anspruch 3, dadurch gekennzeichnet, daß die Kathode der Schaltdiode über eine Parallelschaltung einer Kapazität und eines Widerstandes mit dem Verbindungspunkt zwischen den beiden Induktivitäten gekoppelt ist.

FIG.1

FIG.2